# EUROPEAN PATENT APPLICATION

(11) **EP 3 902 313 A1**
(43) Date of publication of application: **27.10.2021**
(21) Application number: 19897593.0
(22) Date of filing: 26.11.2019
(51) Int. Cl.: H04W 24/06, H04B 17/391

(54) **FIELD STRENGTH TESTING METHOD**

(30) Priority: 20.12.2018 CN 201811563761
(71) Applicant: ZTE Corporation, Shenzhen, Guangdong 518057 (CN)
(72) Inventor: WU, Jilong, Shenzhen, Guangdong 518057 (CN)
(74) Representative: Petraz, Gilberto Luigi
(86) International application number: PCT/CN2019/121051
(87) International publication number: WO 2020/125349

(57) **Abstract**

Disclosed is a field strength prediction method, comprising: selecting a first data combination from data sets in a non-target area, the agreement degree of between fluctuation patterns of a signal corresponding to the first data combination and a signal corresponding to a second data combination of a target area complies with a preset rule; and training a field strength prediction model for the target area, training samples of the field strength prediction model comprising the first data combination.

## Description

### FIELD OF THE INVENTION

The present disclosure relates to the technical field of communications, in particular to a field strength prediction method for signal covered areas.

### BACKGROUND OF THE INVENTION

Environmental factor is an important factor that determines model accuracy in the relevant technical fields of field strength prediction, etc. At present, there are mainly two approaches for using environment information. That are, first, carrying out fine manual measurement on various factors of an environment on site, and second, ignoring environment information and then modeling by using overall data sets (full data) within a non-target region as training samples. By means of the first approach, the environment information can be fully used, and higher accuracy can be achieved in modeling for prediction of the field strength. However, the measurement of the environment information costs a large amount of manpower and material resources, has a very high time cost, and is thus not suitable for a quick modeling requirement. By means of the second approach, although the quick modeling requirement may be met, a model generated thereby has relatively low accuracy and a relatively great error as what used as training samples for modeling are all those known data sets, and is not quite applicable for solving a field strength coverage problem.

Therefore, there is an urgent need for a field strength prediction method which does not need to consume a large amount of manpower and material resources and also has relatively high accuracy.

### SUMMARY OF THE INVENTION

In order to solve the above-mentioned problem, the present disclosure provides a field strength prediction method, comprising: selecting a first data combination from data sets of a non-target region, wherein a consistency degree of fluctuation patterns between a signal corresponding to the first data combination and a signal corresponding to a second data combination of a target region complies with a preset rule; and training a field strength prediction model for a target region, wherein training samples of the field strength prediction model include the first data combination.

In order to achieve the above-mentioned objective, an embodiment of the disclosure further provides an electronic device, comprising: at least one processor; and a memory communicatively connected to the at least one processor, wherein the memory stores instructions that are executable by the at least one processor, the instructions are executed by the at least one processor so that the at least one processor carry out the method as described in above respective aspects.

In order to achieve the above-mentioned objective, an embodiment of the present disclosure further provides a non-transitory computer-readable storage medium which stores computer-executable instructions, wherein the computer-executable instructions are configured to carry out the method as described in above respective aspects.

In order to achieve the above-mentioned objective, an embodiment of the present disclosure further provides a computer program product which includes a computer program stored on a non-transitory computer-readable storage medium, wherein the computer program includes program instructions which, when being executed by a computer, cause the computer to carry out the method as described in above respective aspects.

### BRIEF DESCRIPTION OF THE DRAWINGS

The accompanying drawings described herein serve to provide a further understanding of the present disclosure and constitute a part of the present disclosure. The schematic embodiments of the present disclosure and description thereof are used to explain the present disclosure and do not constitute improper limitation thereto. In the accompanying drawings:
Fig. 1 illustrates a field strength prediction process according to Embodiment 1 of the present disclosure;
Fig. 2 illustrates a specific operation flow according to Embodiment 1 of the present disclosure;
Fig. 3 is a comparison chart of MAEs of a field strength prediction method according to Embodiment 2 of the present disclosure against MAEs of an existing field strength prediction approach;
Fig. 4 is a comparison chart of MAEs of a field strength prediction method according to Embodiment 3 of the present disclosure against MAEs of an existing field strength prediction approach; and
Fig. 5 is a schematic diagram showing hardware structure of an electronic device for performing a field strength prediction method according to an embodiment of the present disclosure.

### DETAILED DESCRIPTION OF THE EMBODIMENTS

In order to make the objective, the technical solution and advantages of the present disclosure more clear, the technical solution of the present application will be described clearly and completely in conjunction with particular embodiments of the present disclosure and corresponding drawings hereinafter. Apparently, the described embodiments are only some rather than all of the embodiments of the present disclosure. On the basis of the embodiments of the present disclosure, all other embodiments obtained by those of ordinary skill in the art without involving any inventive effort should fall within the scope of protection of the present disclosure.

### Embodiment 1

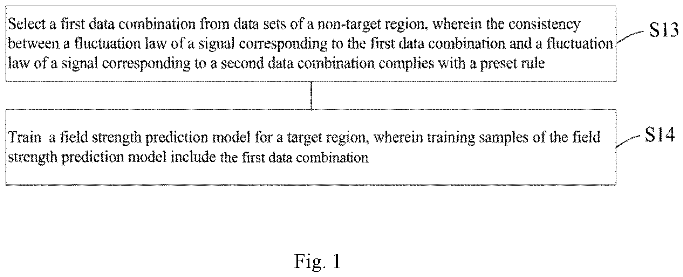

Fig. 1 illustrates a field strength prediction process of Embodiment 1 of the present disclosure. The field strength prediction method comprises: S13: a first data combination is selected from data sets of a non-target region, a consistency degree of fluctuation patterns between a signal corresponding to the first data combination and a signal corresponding to a second data combination of a target region complying with a preset rule; and S14: training of a field strength prediction model with respect to a target region is performed, training samples of the field strength prediction model including the first data combination

Compared with an existing approach that all data sets of a non-target region are adopted for modeling of a target region, in the field strength prediction method provided by the embodiments of the present disclosure, the first data combination is selected from all the data sets of the non-target region and serves as a training sample of a field strength prediction model, and the consistency degree between the fluctuation patterns of the signal corresponding to the first data combination and the signal corresponding to the second data combination complies with a preset rule, that is, the first data combination selected in the present disclosure correlates with the second data combination to a certain extent, which means data in the data sets of the non-target region that has significant difference from the fluctuation pattern of the second data combination is removed. Therefore, by taking the first data combination as a training sample of the field strength prediction model, the field strength prediction model is enabled to have higher accuracy, and on-site measurement of various factors of an environment is not necessary in the prediction method.

Specifically, a non-target region may be divided into a plurality of sub-regions. A target region may also be further divided into a plurality of sub-regions, but the target region may generally be one sub-region. The target region may be one sub-region of the non-target region. For example, the target region includes N cells and each cell is one sub-region, then the kth cell of the N cells may be taken as a target region. Both N and k are positive integers, and the value of k is greater than 0 but not greater than N.

Elements of both the first data combination and the second data combination may include an antenna working parameter of a base station, which is called a working parameter for short. In practical application, for a cell where weak coverage of a wireless signal occurs, an antenna working parameter of a base station can be adjusted to improve a signal coverage strength exerted on the weak coverage area in the current cell by the base station. The antenna working parameter generally has a plurality of dimensions, such as transmission power, antenna azimuth, antenna downtilt angle and antenna height. As a result of that the working parameter has many dimensions to render a large range of direction and magnitude of adjustment, the transmission power in reality usually operates at the maximum power, and any adjustment of the antenna height would cause a drastic change in signal coverage strength, the signal coverage strength is thereby generally adjusted by means of adjustment of the antenna azimuth.

The elements in the first data combination may further include other signal data, such as a distance and a relative position between a sub-region in the non-target region and the base station, signal strength of the sub-region, and the like. For the same reasoning, the elements in the second data combination may also include a distance and a relative position between the non-target region and the base station and the like.

There are steps S11 and S12 to be performed before S13.

In S11, the data sets of the non-target region are divided into multiple groups of working parameter data according to value change extents of working parameter; and in S12, the second data combination of the target region is divided into multiple groups of second data according to value change extents of working parameter.

As the above analysis, since the signal coverage strength is generally adjusted by means of adjustment of the antenna azimuth in the practical application, the working parameter adopted in S11 and S12 may be an antenna azimuth. That is, the data sets in S11 are divided into multiple groups of working parameter data according to angle difference of the antenna azimuth relative to the base station, and the data sets in S12 are also divided into multiple groups of second data according to angle difference of the antenna azimuth relative to the base station.

The working parameter in S11 and S12 may certainly also include, but not limited to transmission power, antenna azimuth, antenna downtilt angle, antenna height, etc. Specifically, the working parameter in S11 and S12 may be a single type of working parameter with working parameter data of unanimous, and single working parameter data means that as for the working parameter therein, there is only one parameter or one dimension, for example, there is only one type of working parameter like antenna azimuth or only one type of working parameter like antenna height. In addition, the working parameter in S11 and S12 may also include at least two types of parameters, for example, two types of parameters like antenna azimuth and antenna height. It is possible to group data in the data sets that has the same antenna azimuth and antenna height into one group of working parameter data, and to group data in the second data combination that has the same antenna azimuth and antenna height into one group of second data.

As stated above, the elements in the first data combination may further include the distance between a sub-region in the non-target region and the base station. Further, the elements in the data sets of the non-target region may also include other signal data, such as distances between all sub-regions in the non-target region and the base station. S11 may further include: sorting signal data corresponding to each group of working parameter data in terms of the distance to form ordered signal data, the working parameter data being the single working parameter data.

In S13, target working parameter data is selected from the multiple groups of working parameter data obtained in S11, and all the whole of the target working parameter data constitutes a first data combination. The correlation between the target working parameter data and the multiple groups of second data complies with a preset rule, that is, a consistency degree of fluctuation patterns between a signal corresponding to the target working parameter data and a signal of at least one group of second data complies with the preset rule.

In S13, the consistency degree of the fluctuation patterns between the signal corresponding to the first data combination and the signal corresponding to the second data combination may be calculated based on a correlation coefficient, e.g., a Pearson correlation coefficient. Specifically, a correlation extent between the target working parameter data and the second data may be calculated based on the Pearson correlation coefficient.

S13 specifically includes: measuring consistency degrees between fluctuation patterns of signals corresponding to all groups of (working parameter) data in the data sets of the non-target region and the fluctuation pattern of the signal corresponding to the second data combination, then sorting the groups of data in terms of the consistency degrees, and taking those groups of data corresponding to the consistency degrees in top ranks as the first data combination or taking those groups of data corresponding to the consistency degrees within a preset range as a first data combination. For example, groups of data corresponding to the consistency degrees in top 10 or 20, etc. are taken as the first data combination, that is, those groups of data that have higher consistency degrees with the second data combination are searched out from all the data sets to be taken as the first data combination, and those groups of data having lower consistency degrees are excluded. For another example, those groups of data corresponding to the consistency degrees between 0.8 and 1 are taken as the first data combination. The value of consistency degree is no more than 1, and if the consistency degree is of 1, then it indicates that fluctuation patterns of two groups of data are completely the same.

In S14, the training samples of the field strength prediction model may further include second data, that is, the training samples of the field strength prediction model include the first data combination and the second data combination. In addition to the second data combination, the target region may also include a third data combination. The third data combination may serve as a test sample of the field strength prediction model for verifying an effect of the field strength prediction model when it is used for field strength prediction. Specifically, all data sets in the target region may be divided into multiple groups of data according to value change extent of working parameter. One third of the multiple groups of data combination are of the second data combination (i.e., value change extents of working parameter have been known), and the remaining two thirds groups are of the third data combination (i.e., value change extents of working parameter may be deemed to be unknown). A data volume of the third data combination is greater than a data volume of the second data combination such that the value change extents of working parameter of the test samples are more than the known value change extents of working parameter, and the prediction effect of the field strength prediction model can thus be verified more effectively. For example, there are six working parameter values in all the data sets of the target region (taking antenna azimuth as an example, they are 10 degrees, 20 degrees, 30 degrees, 40 degrees, 50 degrees and 60 degrees), and those groups of data combination corresponding to the antenna azimuth being of 10 degrees and 20 degrees may be selected as the second data combination, and the remaining groups of data combination can be selected as the third data combination.

The ratio of the data volume of the third data combination to the data volume of the second data combination may certainly also be other values, for example, one fourth of the multiple groups of data combination are of the second data combination (i.e., value change extents of working parameter have been known), and the remaining three fourths groups are of the third data combination (i.e., value change extents of working parameter may be deemed to be unknown). In addition, in the multiple groups of data combination, it is also possible that the data volume of the third data combination is less than or equal to the data volume of the second data combination.

It can be seen that the training samples of the field strength prediction model include the first data combination and the second data combination, and the test samples include the third data combination. In order to avoid the problem of redundancy and low prediction accuracy, for the field strength prediction model, the ratio of the data volume of training samples to the data volume of test samples is between 5 and 15, namely, 8, 10 or 12, etc. Specifically, the ratio of the sum of the data volumes of the first data combination and the second data combination to the data volume of the third data combination is between 5 and 15.

The field strength prediction model of the embodiments of the present disclosure may be a model in the field of deep learning, such as a fully-connected neural network model, and may also be a model in the field of machine learning, such as an Xgboost model.

After S14, the method may further include S15: predicting field strength of the target region based on the field strength prediction model. Relevant data of the target region is input into the field strength prediction model, and a predicted field strength value of the target region is obtained after the field strength prediction model carries out calculation.

Between S14 and S16, the method may further include S15: verifying the effectiveness of the field strength prediction model, and then proceeding to S16 if the field strength prediction model is effective, otherwise, suspending or terminating the process. A predicted field strength value of the target region is obtained by inputting the test samples into the field strength prediction model, and the obtained predicted field strength value is compared with an actual field strength value by using a mean absolute error, MAE, method so as to obtain a difference A between the predicted field strength value and the actual field strength value. In the case of the existing approach that all data sets of a non-target region are used as a training sample for modeling, a difference between a predicted field strength value obtained thereby and an actual field strength value is B. By comparing A with B, the effectiveness of the field strength prediction model of the embodiments of the present disclosure can be assessed.

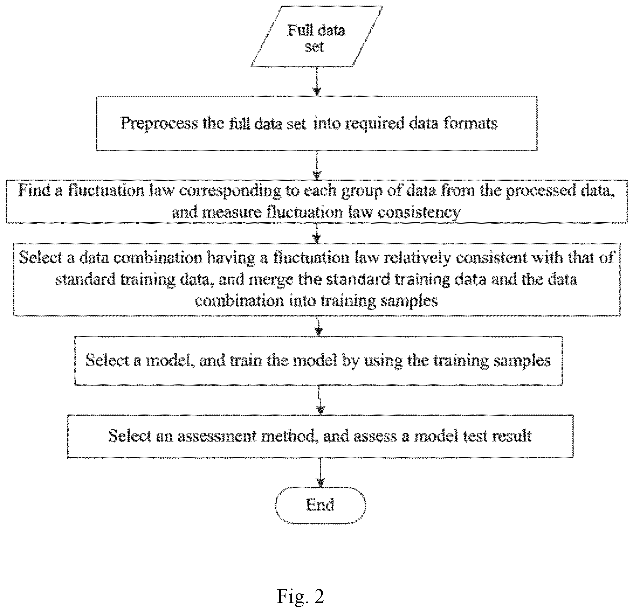

Fig. 2 illustrates a specific operation flow of the field strength prediction method of embodiment 1 of the present disclosure. First, a full data set, i.e., all of the data sets, of a non-target region is obtained. The full data set is then preprocessed into a required data format. Specifically, the full data set may be classified into the required data format according to the value change extents of working parameter. and a fluctuation pattern corresponding to each group of data is found from the processed data, that is, acquiring the fluctuation pattern of each group of data. Then, data that corresponds to a target region is selected from the processed data as standard training data, a data combination having a fluctuation pattern relatively consistent with that of the standard training data are selected from all the processed data, and then the standard training data and the data combination are merged into training samples to enable higher correlation among the model training samples so that a model having higher accuracy is facilitated to be trained. Finally, the model is selected and trained by using the training samples, and an assessment method is selected to assess a test result of the model.

Taking a cell as a target is taken as an example hereinafter. A specific application process in practice of the solution provided in the embodiments of the present disclosure is specified through introduction of Embodiment 2 and Embodiment 3. It can be understood that Embodiment 2 and Embodiment 3 specifically explain the solution provided in Embodiment 1, and should not be deemed as limitation to an application scenario, etc. of the technical solution.

### Embodiment 2

In the embodiment of the present disclosure, a fully-connected neural network that is applied on a full data set composed of data of 67 cells that contains no terrain and landform information is used as a basic model for field strength prediction. Then, how much the model performance has been improved by the method of the technical solution is verified.

The specific implementation steps are as follows.

In S21, data of each of the 67 cells is divided into multiple groups of single working parameter data according to value change extents of working parameter contained in the data of the present cell. Working parameter can include transmission power, antenna azimuth, antenna downtilt angle, antenna height, etc. In S21, the value change extents of working parameter may specifically be angle change extents of an antenna azimuth.

In S22, signal data in each group of single working parameter data in S21 is sorted, in ascending order, in terms of distance from a base station so as to form a group of ordered signal data. Assuming that there are M groups of single working parameter data obtained in S21, M groups of ordered signal data are formed then.

In S23, a cell with an index number of 4 is selected as a target cell from the 67 cells. Assuming that there are X value change extents of working parameter included in the target cell, then 1/3 of the X value change extents of working parameter included in the target cell may be taken as value change extents of working parameter that have been known, and data corresponding thereto is taken as standard training data (equivalent to the second data combination in Embodiment 1); and the remaining 2/3 of the X value change extents of working parameter are taken as change extents of working parameter that are unknown, and data corresponding thereto is taken as test data (equivalent to the third data combination in Embodiment 1). As a result of that 1/3 X value change extents of working parameter are selected as the known value change extents of working parameter, the value change extents of working parameter of the test data are more than the change extents that have been known so that the effectiveness of the embodiment can be better verified.

In S24, calculation is carried out on each group of ordered signal data formed in S22, respectively, with respect to each group of single working parameter data contained in the standard training data in S23, so as to obtain Pearson coefficients between the ordered signal data of the single working parameter data and to generate a Pearson coefficient table. Specifically, for example, M is 100 and X is 60, the Pearson coefficients of each group of ordered signal data of 100 groups of ordered signal data relative to 20 groups of standard training data are calculated in sequence, and a Pearson coefficient table is obtained after 2000 times of calculation.

Table 1 is a Pearson coefficient table for every two pieces of different working parameter data in partial cells, wherein a_b represents the bth change extent of working parameter in a cell having the index number of a.

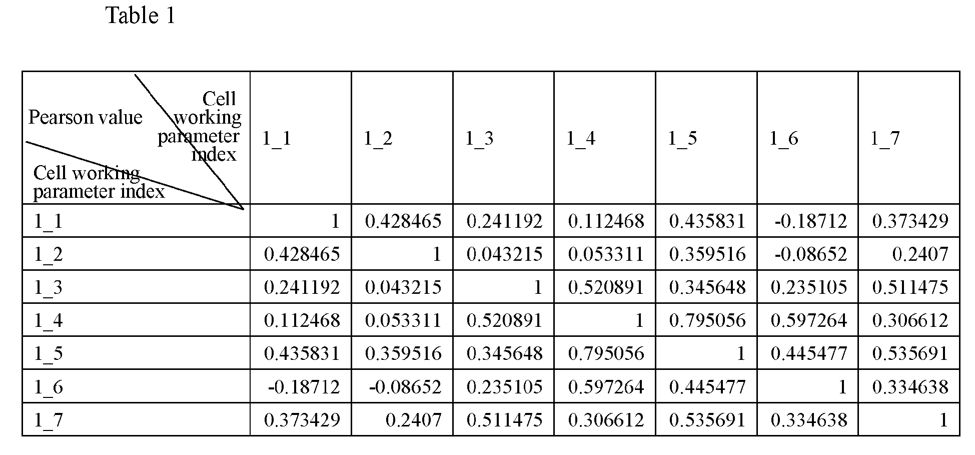

In S25, according to the Pearson coefficient table generated in S24, first ten pieces of non-target cells' single working parameter data that have the most consistent fluctuation patterns with each group of single working parameter in the standard training data are selected. The first ten pieces of non-target cells' single working parameter data that have the most consistent fluctuation patterns are merged with the standard training data and then together serve as a training set of a model so as to train a fully-connected neural network model. The quantity of the most consistent fluctuation patterns is designed to enable the ratio of the data volume of the training set to the data volume of a test set to be within an interval of [5, 15] so as to avoid redundancy or decrease of prediction accuracy caused by ineffective data.

In S26, the test data in S23 is predicted by using the neural network model trained in S25, and a mean absolute error (MAE) is taken as an assessment standard for model prediction performance. A MAE of the cell having the index number of 4 that is obtained in the embodiment of the present disclosure is 4.53 dB. If, as that of the existing approach, the remaining 66 cells are used as training data to train the model, then a prediction MAE under the same experiment condition is 5.96 dB. It can be seen that, the prediction MAE of the embodiment of the present disclosure can decrease by 1.43 dB.

In S27, different cells in the 67 cells are selected as a test set, and S23 to S26 are repeated. Relative to actual field strength, an average of MAEs of predicted field strength in 13 test cells obtained through the field strength predicted method of the embodiment of the present disclosure decreases by 1.77 dB than that through an existing method where environment information is ignored and used is full data.

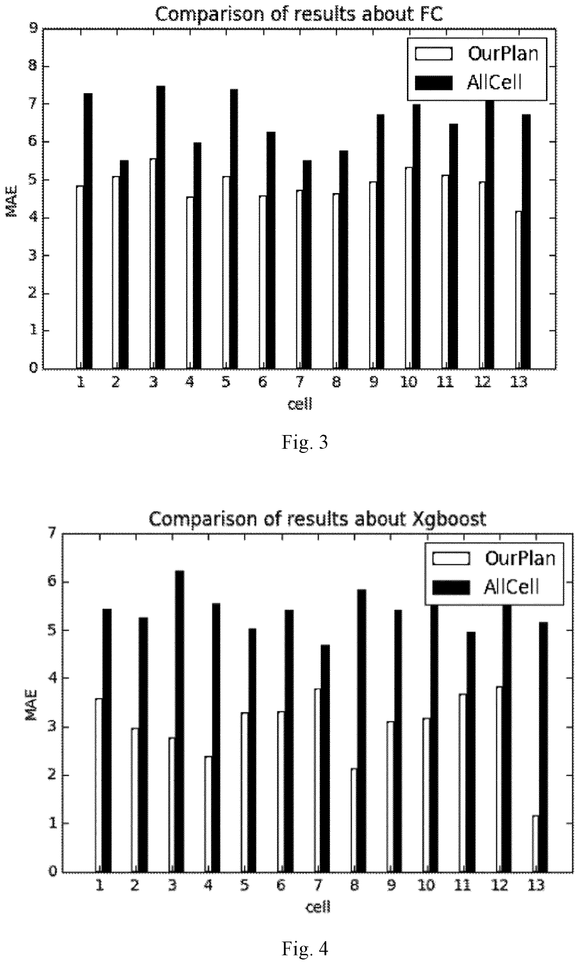

Fig. 3 illustrate MAE comparison relative to actual field strength between MAEs of predicted field strength of 13 test cells in the embodiment of the present disclosure and MAEs of the existing method where environment information is ignored and used is full data. In Fig. 3, white blocks are the MAEs of predicted field strength of the 13 test cells in the embodiment of the present disclosure relative to actual field strength, and black blocks are the MAEs of the existing method using full data.

Table 2 illustrates MAE values of predicted field strength of the 13 test cells relative to actual field strength, and MAE values of the existing method using full data, which correspond to Fig. 3. Relative to actual field strength, an average of the MAEs of predicted field strength of the 13 test cells obtained through the field strength predicted method of the embodiment of the present disclosure decreases by 1.77 dB than that through the existing method where environment information is ignored and used is full data.

**Table 2**

| Cell index number | MAEs in Embodiment 2 | MAEs in existing training by using full data |
|---|---|---|
| 1 | 3.587629358 | 5.421944054 |
| 2 | 2.967377872 | 5.25154632 |
| 3 | 2.763458363 | 6.230814503 |
| 4 | 2.376444463 | 5.547978225 |
| 5 | 3.283629545 | 5.022375316 |
| 6 | 3.3105763 | 5.404011243 |
| 7 | 3.773869306 | 4.680627278 |
| 8 | 2.141811282 | 5.840410583 |
| 9 | 3.105079772 | 5.416429221 |
| 10 | 3.172318534 | 5.756473165 |
| 11 | 3.6603871 | 4.951372115 |
| 12 | 3.836127682 | 5.726558758 |
| 13 | 1.154379446 | 5.170090277 |
| Mean value | 3.010237617 | 5.41697162 |

### Embodiment 3

The difference between the present embodiment and Embodiment 2 lies in that the fully-connected neural network is changed to an Xgboost model to serve as a basic model for field strength prediction. S31 to S34 in the specific steps of the present embodiment are completely the same as S21 to S24 in Embodiment 2, and the difference occurs at S3 5 to S37 lies in a respect of change of the basic model.

The specific implementation steps are as follows.

In S31, data of each of the 67 cells is divided into multiple groups of single working parameter data according to value change extents of working parameter contained in the data of the present cell. Working parameters can include transmission power, antenna azimuth, antenna downtilt angle, antenna height, etc. In S31, the value change extents of working parameter may specifically be angle change extents of an antenna azimuth.

In S32, signal data in each group of single working parameter data in S31 is sorted, in ascending order, in terms of distance from a base station so as to form a group of ordered signal data. Assuming that there are M groups of single working parameter data obtained in S31, then M groups of ordered signal data are formed.

In S33, a cell with an index number of 4 is selected as a target cell from the 67 cells. Assuming that there are X value change extents of working parameter included in the target cell, then 1/3 of the X value change extents of working parameter included in the target cell may be taken as value change extents of working parameter that have been known, and data corresponding thereto is taken as standard training data (equivalent to the second data combination in Embodiment 1); and the remaining 2/3 of the X value change extents of working parameter are taken as change extents of working parameter that are unknown, and data corresponding thereto is taken as test data (equivalent to the third data combination in Embodiment 1). As a result of that 1/3 X value change extents of working parameter are selected as the known value change extents of working parameter, the value change extents of working parameter of the test data are more than the change extents that have been known so that the effectiveness of the embodiment can be better verified.

In S34, calculation is carried out on each group of ordered signal data formed in S32, respectively, with respect to each group of single working parameter data contained in the standard training data in S33, so as to obtain Pearson coefficients between the ordered signal data of the single working parameter data and to generate a Pearson coefficient table. Specifically, for example, M is 100 and X is 60, the Pearson coefficients of each group of ordered signal data of 100 groups of ordered signal data relative to 20 groups of standard training data are calculated in sequence, and a Pearson coefficient table is obtained after 2000 times of calculation.

Table 1 above is a Pearson coefficient table for every two pieces of different working parameter data in partial cells, wherein a_b represents the bth change extent of working parameter in a cell having the index number of a.

In S35, according to the Pearson coefficient table generated in S24, first ten pieces of non-target cells' single working parameter data that have the most consistent fluctuation patterns with each group of single working parameter in the standard training data are selected. The first ten pieces of non-target cells' single working parameter data that have the most consistent fluctuation patterns are merged with the standard training data and then together serve as a training set of a model so as to train an Xgboost model. The quantity of the most consistent fluctuation patterns is designed to enable the ratio of the data volume of the training set to the data volume of a test set to be within an interval of [5, 15] so that redundancy or decrease of prediction accuracy due to ineffective data can be avoided.

In S36, the test set in S33 is predicted by using the Xgboost model trained in S35, and an MAE is taken as an assessment standard for model prediction performance. A MAE of the cell having the index number of 4 that is obtained in the embodiment of the present disclosure is 2.37 dB. If, as that of the existing approach, the remaining 66 cells are used as training data to train the model, then a prediction MAE under the same experiment condition is 5.54 dB. It can be seen that the prediction MAE of the embodiment of the present disclosure can decrease by 2.17 dB.

In S37, different cells in the 67 cells are selected as a test set, and S33 to S36 are repeated. Relative to actual field strength, an average of MAEs of predicted field strength in 13 test cells obtained through the field strength predicted method of the embodiment of the present disclosure decreases by 2.41 dB than that obtained through the method using full data.

Fig. 4 illustrate MAE comparison relative to actual field strength between MAEs of predicted field strength of 13 test cells in the embodiment of the present disclosure and MAEs of the existing method where environment information is ignored and used is full data. In Fig. 4, white blocks are the MAEs of predicted field strength of the 13 test cells in the embodiment of the present disclosure relative to actual field strength, and black blocks are the MAEs of the existing method using full data.

**Table 3**

| Cell number | MAEs in Embodiment 3 | MAEs in existing training by using full data |
|---|---|---|
| 1 | 4.84023467 | 7.281171702 |
| 2 | 5.090034643 | 5.504752663 |
| 3 | 5.557178068 | 7.487299531 |
| 4 | 4.533818793 | 5.965596034 |
| 5 | 5.083300158 | 7.382730095 |
| 6 | 4.575730595 | 6.253292809 |
| 7 | 4.716869293 | 5.503614592 |
| 8 | 4.64386089 | 5.77665165 |
| 9 | 4.939761061 | 6.707330756 |
| 10 | 5.326558269 | 6.988647401 |
| 11 | 5.133584071 | 6.469803594 |
| 12 | 4.94903948 | 8.473235813 |
| 13 | 4.171321552 | 6.710995883 |
| Mean value | 4.889330119 | 6.654240194 |

Table 3 illustrates MAE values of predicted field strength of the 13 test cells relative to actual field strength, and MAE values of the existing method using full data, which correspond to Fig. 4. Relative to actual field strength, an average of the MAEs of predicted field strength of the 13 test cells obtained through the field strength predicted method of the embodiment of the present disclosure decreases by 2.41 dB than that through the existing method where environment information is ignored and used is full data.

An embodiment of the present disclosure provides a non-transitory (non-volatile) computer storage medium which stores computer-executable instructions, and the computer-executable instructions can carry out the method according to any of the foregoing process embodiments.

An embodiment of the present disclosure provides a computer program product which includes a computer program stored on a non-transitory computer-readable storage medium. The computer program includes program instructions which, when being executed by a computer, cause the computer to carry out the method according to any of the foregoing process embodiments.

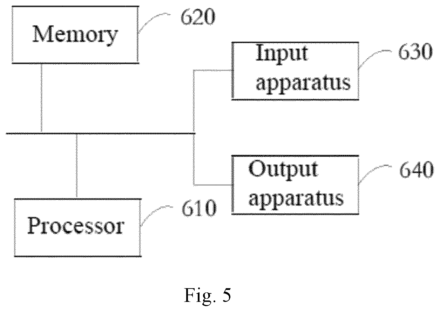

Fig. 5 is a schematic diagram showing hardware structure of an electronic device for performing a field strength prediction method according to an embodiment of the present disclosure. As shown in the figure, the device includes one or more processors 610 and a memory 620. One processor 610 is taken as an example. The device may further include: an input apparatus 630 and an output apparatus 640.

The processor 610, the memory 620, the input apparatus 630, and the output apparatus 640 may be connected via a bus or other ways. In Fig. 5, connection via a bus is taken as an example.

As a non-transitory computer-readable storage medium, the memory 620 can be used to store non-transitory software program, and non-transitory computer executable program and modules. The processor 610 executes various functional applications and data processing of the electronic device (i.e., realizing the processing methods of the foregoing process embodiments) by running the non-transitory software program, instructions, and modules stored in the memory 620.

The memory 620 may include a program storage area and a data storage area. The program storage area may store an operating system and an application program required by at least one function. The data storage area may store data and the like. In addition, the memory 620 may include a high-speed random access memory, and may also include a non-transitory memory, such as at least one magnetic disk storage part, a flash memory part, or other non-transitory solid storage parts. In some embodiments, the memory 620 may optionally include memories remotely arranged relative to the processor 610, and these remote memories may be connected to a processing device through a network. Examples of the aforementioned network include, but are not limited to, Internet, corporate intranet, local area network, mobile communication network, and any combinations of them.

The input apparatus 630 may receive input digital or character information, and generate a signal input. The output apparatus 640 may include a display device such as a display screen.

Said one or more modules are stored in the memory 620, and carry out, when executed by the one or more processors 610, the method of any of the foregoing process embodiments.

The foregoing products can carry out the methods provided in the embodiments of the present disclosure, and have corresponding modules to execute functions of the methods and also bring along beneficial effects. For technical details not described in detail in this embodiment, reference can be obtained from the methods provided in the embodiments of the present disclosure.

The objectives, technical solutions, and beneficial effects of the present invention are further described in detail by the specific embodiments described above. It should be understood that those described above are merely specific embodiments of the present invention, and are not used to limit the present invention. Any modifications, equivalent replacements, improvements etc. that are made within the principle of the present invention shall fall within the scope of protection of the present invention.

## Claims

1. A field strength prediction method, **characterized by** comprising:
selecting a first data combination from data sets of a non-target region, wherein a consistency degree of fluctuation patterns between a signal corresponding to the first data combination and a signal corresponding to a second data combination of a target region complies with a preset rule (S13); and
training a field strength prediction model for a target region, wherein training samples of the field strength prediction model include the first data combination (S14).

2. A field strength prediction method according to claim 1, **characterized in that** , elements of both the first data combination and the second data combination include a working parameter;
wherein before selecting the first data combination from the data sets of the non-target region, the method further comprises:
dividing the data sets into multiple groups of working parameter data according to value change extents of working parameter, and
dividing the second data combination of the target region into multiple groups of second data according to the value change extents of working parameter; and
wherein said selecting a first data combination from data sets of a non-target region, wherein a consistency degree of fluctuation patterns between a signal corresponding to the first data combination and a signal corresponding to a second data combination of a target region complies with a preset rule, includes:
selecting at least one group of target working parameter data from the multiple groups of working parameter data, wherein all the target working parameter data constitutes the first data combination, and a correlation extent between the target working parameter data and at least one group of the second data complies with a preset rule.

3. A field strength prediction method according to claim 2, **characterized in that**, the working parameter includes an antenna azimuth of a base station.

4. A field strength prediction method according to claim 2, **characterized in that**, the correlation extent between the target working parameter data and the second data is calculated through a Pearson correlation coefficient, or the consistency degree of fluctuation patterns between the signal corresponding to the first data combination and the signal corresponding to the second data combination is calculated through a Pearson correlation coefficient.

5. The field strength prediction method according to any one of claims 1 to 4, **characterized in that**, said selecting a first data combination from data sets of a non-target region, wherein a consistency degree of fluctuation patterns between a signal corresponding to the first data combination and a signal corresponding to a second data combination of a target region complies with a preset rule, includes:
measuring consistency degrees between fluctuation patterns of signals corresponding to all groups of data in the data sets of the non-target region and the fluctuation pattern of the signal corresponding to the second data combination, sorting the groups of data in terms of the consistency degrees, and taking the groups of data corresponding to the consistency degrees in top ranks as the first data combination, or taking the groups of data corresponding to the consistency degrees within a preset range as the first data combination.

6. A field strength prediction method according to claim 2, **characterized in that**, the training samples of the field strength prediction model further include the second data combination, and the target region further includes a third data combination in addition to the second data combination, the third data combination being of a test sample of the field strength prediction model.

7. A field strength prediction method according to claim 6, **characterized in that**, a ratio of data volume of the training samples of the field strength prediction model to data volume of the test sample of the field strength prediction model is between 5 and 15.

8. A field strength prediction method according to claim 6, **characterized in that**, the field strength prediction model for the target region is a fully-connected neural network or an Xgboost model.

9. A field strength prediction method according to claim 2, **characterized in that**, an element in the data sets further includes distance between a sub-region of the non-target region and a base station, and said dividing the data sets into multiple groups of working parameter data according to the value change extents of working parameter further includes: sorting signal data of each group of working parameter data in terms of the distance, the working parameter data being of single working parameter data.

10. A field strength prediction method according to claim 1, **characterized in that**, the target region is independent of the non-target region, or the target region is a sub-region of the non-target region.

11. A field strength prediction method according to claim 1, **characterized in that**, after training the field strength prediction model for the target region, the method further comprises predicting field strength of the target region based on the field strength prediction model.

12. An electronic device, **characterized by** comprising:
at least one processor (610); and
a memory (620) communicatively connected to the at least one processor,
wherein the memory stores instructions that are executable by the at least one processor, and the instructions are executed by the at least one processor so that the at least one processor carry out the method according to anyone of claims 1 to 11.

13. A non-transitory computer-readable storage medium which stores computer-executable instructions, wherein the computer-executable instructions are configured to carry out the method according to anyone of claims 1 to 11.
